# EUROPEAN PATENT APPLICATION

(11) **EP 4 428 590 A1**
(43) Date of publication of application: **11.09.2024**
(21) Application number: 24160753.0
(22) Date of filing: 01.03.2024
(51) Int. Cl.: G02B 6/30, G02B 6/42

(54) **OPTICAL COUPLER MOISTURE BARRIER**

(30) Priority: 06.03.2023 FI 20235261
(71) Applicant: Nokia Solutions and Networks Oy, 02610 Espoo (FI)
(72) Inventor: HORTH, Alexandre, Astoria, NY (US); HOCHBERG, Michael, New York, NY (US); NOVACK, Ari, Seattle, WA (US); ZHENG, Jiabao, Fremont, CA (US); STRESHINSKY, Matthew, Taos, NM (US)
(74) Representative: Nokia EPO representatives

(57) **Abstract**

A photonic chip is especially sensitive to damp heat, because the encapsulation oxides that are used in standard wafer fabrication are typically deposited at lower temperatures and are of lesser quality. Accordingly, atomic layer deposition (ALD) is used to deposit a multi-layer, thinfilm stack comprising alternating layers of dielectric layers and moisture barrier layers, e.g. metal oxide or semiconductor nitride, thin enough to be optically compatible with optical input/outputs, such as optical edge couplers in or on the chip. The ALD deposited layers are of high quality and protect the moisture sensitive oxide forming the majority of layers in the chip.

## Description

### TECHNICAL FIELD

The present invention relates to an optical coupler moisture barrier.

### BACKGROUND

Photonics products are typically composed of various elements, which may include fibers, photonic chips implementing photonic integrated circuits (PIC), and electronic components, such as drivers and transimpedance amplifiers (TIAs), wire-bonded or flip-chip bonded onto a carrier substrate assembled in one package. The package may be hermetically sealed, to protect the products from the environment, but hermeticity comes with tradeoffs, such as manufacturing complications and cost. Depending on the product, sometimes hermeticity is a requirement, and other times non-hermetic packages are an option. A desirable feature of packages would be the ability of having non-hermetic packages that can pass some of the qualification tests, such as the damp heat test, which are typically standardized in terms of temperature, humidity and time by Telcordia.

A PIC is especially sensitive to damp heat, because the encapsulation oxides that are used in standard wafer fabrication are typically deposited at lower temperatures and are of lesser quality (non-stoichiometric) than thermal oxide, and may also be under higher stresses. The lower quality oxide will tend to absorb water during damp heat testing, which will change the properties of the oxide, such as stress and refractive index.

### SUMMARY OF THE INVENTION

An optical edge coupler of a photonic chip may guide a large and delocalized mode (~10 µm of diameter), which may significantly overlap with the encapsulation oxide. In the presence of damp heat, an oxide can absorb water and the resulting refractive index change may impact the properties of optical edge couplers, such as insertion loss and polarization dependent loss. The changes in properties can exceed 1 dB in change which is highly undesirable. Preferably, the changes should be no more than 0.5 dB and be resilient to the point that no measurable change is seen under damp heat. The use of conventional hermetic packages seals the PIC from the environment, but results in larger and more expensive packages that do not necessarily meet form-factor standards.

Some embodiments may overcome some of the above-mentioned shortcomings of prior art by utilizing a higher quality deposition process, such as atomic layer deposition (ALD), in order to deposit a moisture barrier comprising a multi-layer stack of dielectric materials, thin enough to be optically compatible with optical couplers integrated on photonic chips. Ideally, the ALD layers are of high quality and protect the moisture sensitive oxide underneath.

Accordingly, the present invention relates to an apparatus comprising a photonic a photonic chip comprising an optical edge coupler for end-coupling an external optical waveguide to the photonic chip, the optical edge coupler having one end at an edge of the chip; and a coating on, at least, a part of the edge of the chip over the one end of the optical edge coupler, the coating being a stack interleaving first and second dielectric layers of different material composition, the stack including at least 2 interfaces between adjacent ones of the first and second layers. The external optical waveguide may be, e.g., an optical fiber or an optical waveguide of another photonic chip.

In some implementations, the coating includes at least four of the layers. In some implementations, the coating may have a thickness of 10 to 150 nanometers. In some implementations, the coating may have a thickness of 25 to 100 nanometers.

In any of the above implementations, each of the layers may be less than 25 nanometers thick.

In any of the above implementations, the coating may cover at least half of a surface of the photonic chip.

In any of the above implementations, each second layer may be one of a silicon nitride layer, aluminum oxide layer, and a hafnium oxide layer.

In any of the above implementations, each first layer may be a silicon oxide layer. In some implementations, the coating starts and ends with a silicon oxide layer.

In any of the above implementations, each second layer may be thinner than each first layer.

In any of the above implementations, the apparatus may comprise a carrier, wherein the photonic chip is attached along a facing surface of the carrier; and wherein the coating is disposed over at least a part of the surface.

In any of the above implementations, the apparatus may further comprise a non-hermetic package including a substrate, the photonic chip being mounted on a surface of the substrate and being located in the package, the coating substantially protecting the optical edge coupler from ambient moisture.

A related aspect of the present disclosure provides a method comprising performing atomic layer deposition to coat at least a part of an edge of a photonic chip with a stack of at least three dielectric layers, adjacent ones of the dielectric layers having different material compositions. In some implementations of the method, the part may be adjacent one end of an optical fiber coupler located in the photonic chip. In some implementations of the method, the performing produces the stack such that thicknesses of the layers of the stack alternate thereacross. In any of the above implementations of the method, the atomic layer deposition may be performed after soldering the photonic chip to a carrier.

### BRIEF DESCRIPTION OF THE DRAWINGS

Exemplary embodiments will be described below in greater detail with reference to the accompanying drawings, which may not be to scale, and, wherein:
Figure 1 is a top view of a photonic chip device in accordance with an embodiment of the present disclosure;
Figure 2 is a cross-sectional side view of the photonic chip device of Fig. 1;
Figure 3 is a cross-sectional side view of the photonic chip device of Fig. 1 coupled to an optical fiber;
Figure 4A is a side view of a photonic chip device in accordance with another embodiment of the present disclosure;
Figure 4B is an end view of the photonic chip device of Fig. 4A;
Figure 5 is a cross-sectional side view of a moisture barrier thin-film stack of the photonic chip device of Fig. 1;
Figure 6 is a cross-sectional side view of an alternative moisture barrier thin-film stack of the photonic chip device of Fig. 1;
Figure 7 illustrates plots of PDL over time for unprotected photonic chip devices and protected photonic chip devices;
Figure 8 is a schematic cross-sectional side view of a carrier-mounted photonic chip device having the moisture barrier coating located in a non-hermetic package.

### DETAILED DESCRIPTION

While the present teachings are described in conjunction with various embodiments and examples, it is not intended that the present teachings be limited to such embodiments. On the contrary, the present teachings encompass various alternatives and equivalents, as will be appreciated by those of skill in the art.

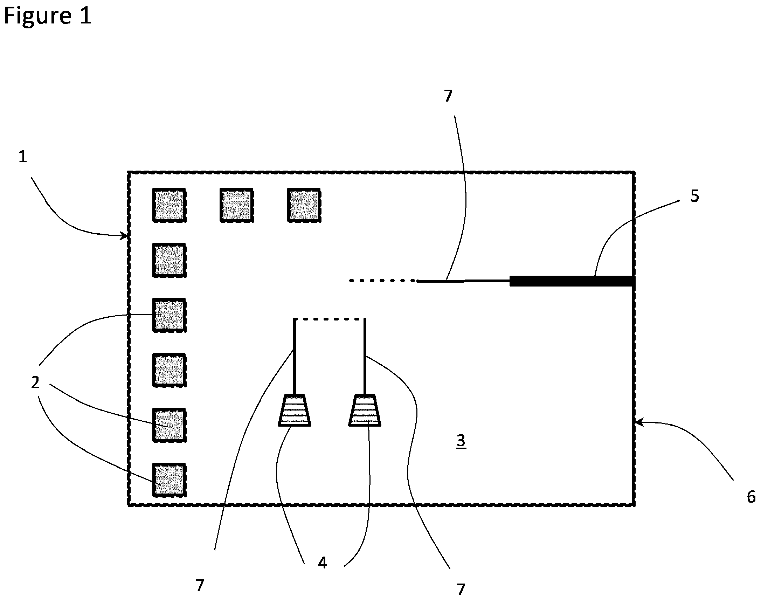

With reference to Figs. 1 to 3, a photonic chip 1 may include electrical input/output (IOs) pads 2, typically on an upper surface 3 of the photonic chip1, and optical input/outputs (IOs), such as optical grating couplers 4 on the upper surface 3 and/or optical edge couplers 5, extending into the photonic chip 1 from an edge 6, e.g. substantially vertical side, thereof. The optical grating couplers 4 and the optical edge couplers 5 extend from a surface (upper or edge) of the photonic chip 1, and are optically coupled to optical waveguides 7, which transmit optical signals to and/or from optical or electro-optical components, such as lasers, modulators and photodetectors on an optical device layer 8 within the photonic chip 1. The optical IOs are typically sensitive to moisture, because they optically interact with the outside world via an encapsulation oxide, which is moisture sensitive.

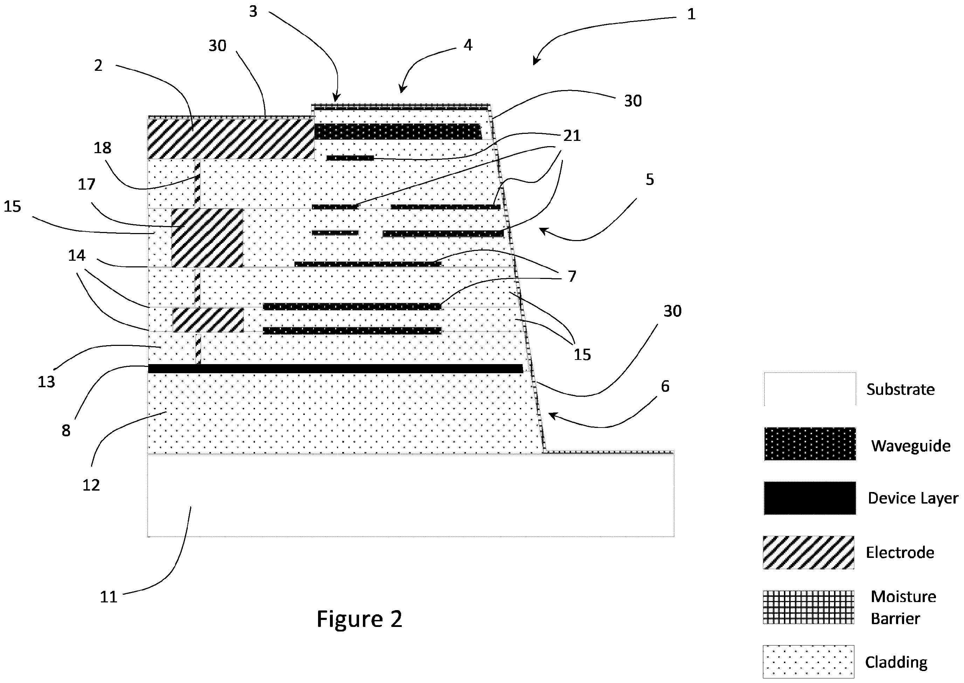

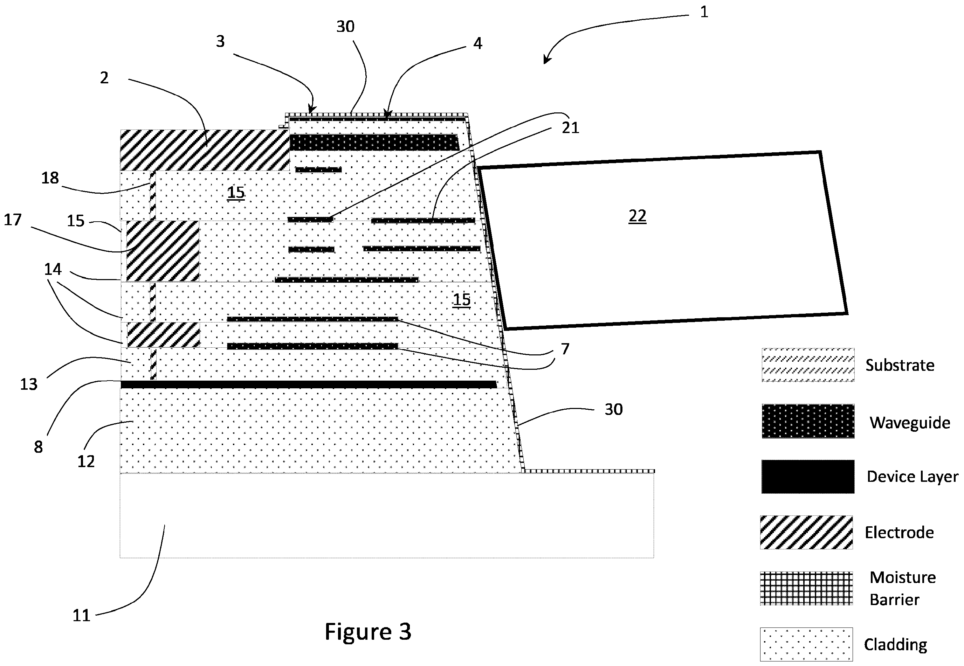

With reference to Figs. 2 and 3, the photonic chip 1 includes a substrate 11, comprised of a suitable material, such as silicon; a lower cladding layer 12; and an upper cladding layer 13, each of the cladding layers 12 and 13 comprised of a dielectric or oxide material, such as silicon dioxide. The optical device layer 8, is formed of a suitable optical waveguide material, i.e. comprised of a material with an index of refraction higher than the surrounding lower and upper cladding layers 12 and 13, such as a semiconductor waveguide material, e.g. silicon, silicon nitride, poly-silicon, silicon oxynitride, silicon-germanium, and germanium. The optical device layer 8 is sandwiched between the lower cladding layer 12 and the upper cladding layer 13. The lower cladding layer 12 may be 2.0 µm to 3.0 µm thick, while the upper cladding layer 13 may be 0.75 µm to 1.5 µm thick.

Above the upper cladding layer 13 is a plurality of layers alternating between etch stop layers 14 and dielectric spacer layers 15. The etch stop layers 14 may be formed of a suitable material, e.g. silicon nitride (Si₃N₄), to provide guidelines for etching each dielectric spacer layer 15 to a predetermined depth. For example, the photonic chip 1 may include a stack of conductive metal structures 17, and vias 18, e.g. comprised of Al or Cu, for electrically connecting the electrical IO pads 2 with electrical or electro-optical components in or above the device layer 8. The etch stop layers 14 may be comprised of a suitable optical waveguide material, i.e. comprise a material with an index of refraction higher than the dielectric layers 15, and providing a sufficient index contrast to confine light. Accordingly, portions of the etch stop layers 14 may be configured into the optical edge coupler 5 and the optical waveguides 7 by etching away selected portions of the etch stop layer material leaving the optical waveguides 7. The optical edge coupler 5 may be comprised of a plurality of parallel optical waveguide segments 21 adjacent one another in the same etch stop layer 14 and/or superposed with one another in superposed spaced-apart etch stop layers 14. The waveguide segments 21 may be arranged in an array, e.g. 2x2, and spaced apart into a configuration with outer ends thereof proximate the edge 6 for coupling to an external optical waveguide, e.g., optical fiber 22. The ends of some of the waveguide segments 21, e.g. in the upper most etch stop layers 14 may taper down to a point, while the ends of other waveguide segments 21 may expand to enhance evanescent coupling therebetween for transmitting optical signals through sequential superposed spaced-apart waveguides 7 between the optical edge coupler 5 and the optical components in the optical device layer 8.

Similarly, the optical grating couplers 4 may couple light upwardly from and/or downwardly towards the optical device layer 8 utilizing a plurality of waveguide segments 21 superposed with one another in superposed etch stop layers 14 spaced apart by dielectric layers 15. The ends of some of the waveguide segments 21, e.g. in the upper most etch stop layers 14 may taper down to a point, while the ends of other waveguide segments 21 may expand to enhance evanescent coupling therebetween. The waveguide segments 21 optically coupling the optical grating couplers 4 to the optical device layer 8 may extend perpendicular to the waveguide segments 21 optically coupling the optical edge coupler 5 to the optical device layer 8.

The coupling of light between waveguide segments 21 and waveguides 7 may proceed downward in the layers until the light reaches the device layer 8. Accordingly, since the optical device layer 8 is between the optical edge coupler 5 and the substrate 11, the light remains separated from the substrate 11, thereby eliminating any light be lost by coupling into the substrate 11.

To seal the photonic chip 1 from humidity a multi-layer thin-film stack 30 may be deposited over the entire photonic chip 1. The thin-film stack 30 may comprise at least 2 layers, preferably 3-20 layers, more preferably 8-12 layers, alternating between a dielectric layer 31, also referred to herein as the moisture barrier layer 31 or a second dielectric layer, and a dielectric layer 32, also referred to herein as the first dielectric layer and comprising, e.g., a first dielectric material such as silicon dioxide (SiO₂). The moisture barrier layers 31 comprise a second different dielectric material with a density that is different, e.g., greater than the first dielectric material in the dielectric layers 32, and/or a material with a higher refractive index (RI) than the dielectric layers 32. Example materials for the moisture barrier layer 31 include metallic oxides, such as e.g. aluminum oxide (Al₂O₃) or hafnium oxide (HfO₂), and semiconductor nitrides, such as silicon nitride Si₃N₄ and gallium nitride GaN. Each of the moisture barrier layers 31 and the dielectric layers 32 may comprise a thickness of between 4 nm and 25 nm, preferably between 5 nm and 10 nm. Normally, Al₂O₃ has a bulk refractive index (RI) of ~1.7, which may not be compatible with some devices, such as some embodiments of the optical edge coupler 5, which may have effective RI of -1.5-1.6. However, a thin film stack 30 including moisture barrier layers 31 comprised of Al₂O₃ has an effective RI that is much smaller, e.g. <1.5, which makes them compatible with the optical edge coupler 5. Preferably, the thin-film stack 30 may be deposited using atomic layer deposition (ALD); however, other suitable methods are possible, such as sputtering, resulting in lower material quality and conformity. The oxide deposited in the back-end-of-line process (PECVD oxides) are not of very good quality partly because they are deposited at low temperature and tend to not be stoichiometric. The normal back-end-of-line oxides are also under stress from the wafer and can relax by absorbing water. In contrast ALD deposit very high quality oxide that is stoichiometric and will not typically absorb water. Accordingly, the moisture barrier layers 31, e.g. Al₂O₃, are better because they are denser.

Multiple interfaces of the ALD deposited moisture barrier layers 31 and the dielectric layers 32 also helps breaking moisture paths, since the paths for water diffusion are broken each time there is new interface and material density changes. The total thickness of the stack 30 may be thinner than 100 nm, and in some embodiments thinner than 50 nm.

In bulk, the RI of Si₃N₄ is 2.0 and Al₂O₃ is 1.7, but when deposited in thin film moisture barrier layers 31 the effective refractive index changes, and tends toward the highest index in the surrounding layers, e.g. the dielectric layers 32 of SiO₂ atRI=1.5, as the thickness of the thin film moisture barrier layers 31 approaches zero.

The thin-film stack 30 may be compatible with the optical edge coupler 5 when the effective refractive index of the thin-film stack 30 is less than the effective refractive index of the optical edge coupler 5, e.g. when the total thickness of the thin-film stack 30 is less than ~50 nm. If the thin-film stack 30 increases in thickness, i.e. approximately 100 nm or more, then the effective index of the thin-film stack 30 becomes comparable to the effective index of the optical edge coupler 5, and the mode of the optical edge coupler 5 may be affected, e.g. the mode spreads and overlaps both the original mode of the optical edge coupler 5 and the thin-film stack 30. If the thickness of the thin-film stack 30 were to increase even further, e.g. greater than 100 nm, then the effective index of the thin-film stack 30 may be greater than the effective index of the optical edge coupler 5 and light would be guided in the thin-film stack 30 instead of in the optical edge coupler 5, which would be undesirable.

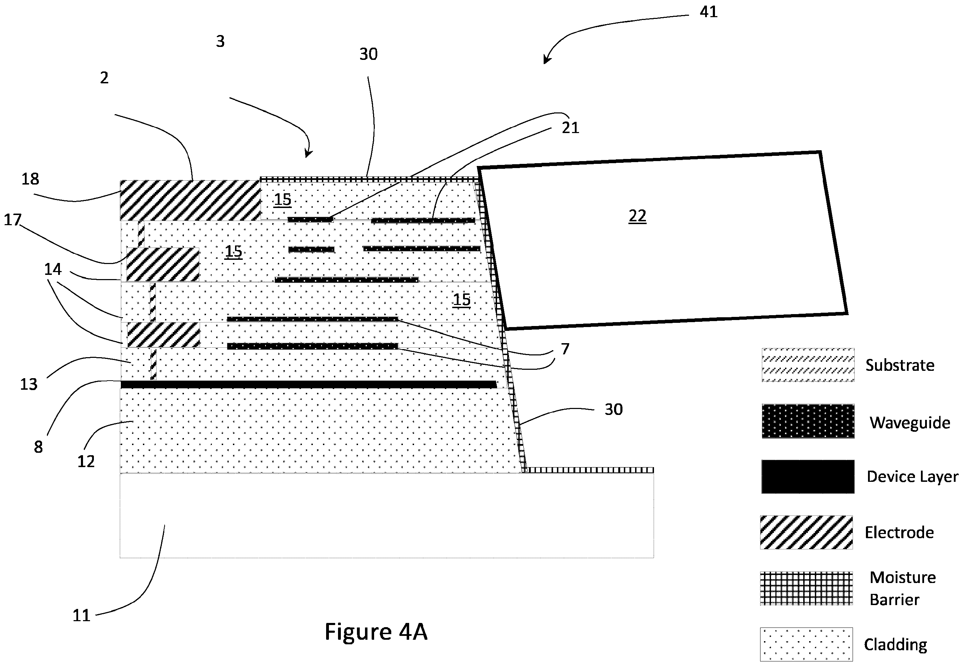

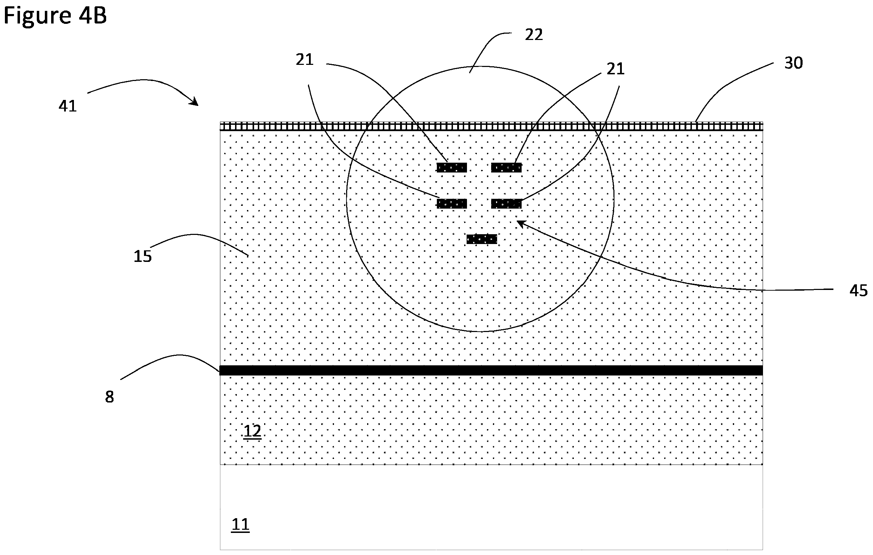

Preferably, the optical edge coupler 5 is unperturbed by the thin-film stack 30; however, with reference to Figs. 4A and 4B, a photonic chip 41 may include an optical edge coupler 45 that includes a portion of the thin-film stack 30. The photonic chip 41 includes most of the same elements as the photonic chip 1, i.e. the substrate 11, formed of a suitable material, such as silicon; the lower cladding layer 12; and the upper cladding layer 13, each of the cladding layers 12 and 13 formed of a dielectric, e.g. oxide material, such as silicon dioxide. The optical device layer 8, is formed of a suitable waveguide material, i.e., a material with an index of refraction higher than the surrounding lower and upper cladding layers 12 and 13, such as a semiconductor waveguide material, e.g., silicon, silicon nitride, poly-silicon, silicon oxynitride, silicon-germanium, and/or germanium. The optical device layer 8 is sandwiched between the lower cladding layer 12 and the upper cladding layer 13. The lower cladding layer 12 may be, e.g., 2.0 µm to 3.0 µm thick, while the upper cladding layer 13 may be, e.g., 0.75 µm to 1.5 µm thick.

The optical edge coupler 45 may comprise a relatively thicker stack, e.g. 4 to 20 alternating layers with a total thickness of approximately 100 nm, similar to each waveguide layer 21, whereby the upper portion of the thin-film stack 30, i.e. on the upper surface 3 of the photonic chip 41, is thick enough to perturb the field of the super-mode of light being coupled from the optical fiber 22. Accordingly, the thin-film stack 30 may comprise an additional waveguide layer that becomes part of the optical edge coupler 45.

When the thickness of a thin-film stack 30 is too thick, i.e. much thicker than waveguide layers 21, the fundamental mode normally supported by the optical edge coupler 45 is no longer the super-mode created by the waveguide arrangement, but instead becomes a mode guided in slab-like waveguide of the thin-film stack 30, which is undesirable.

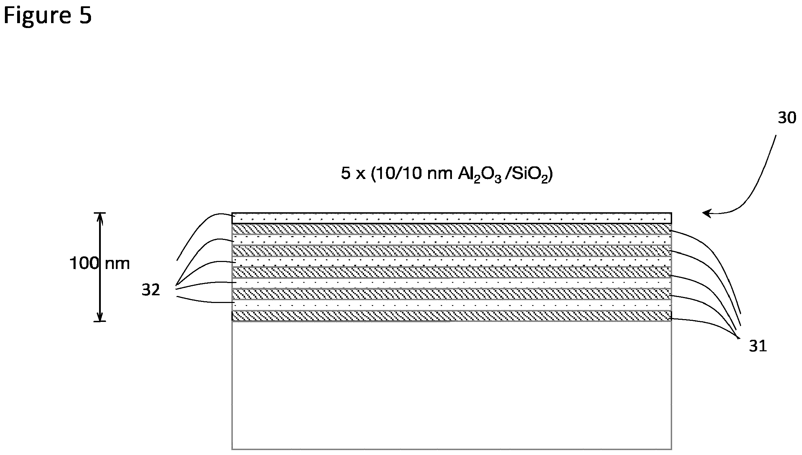

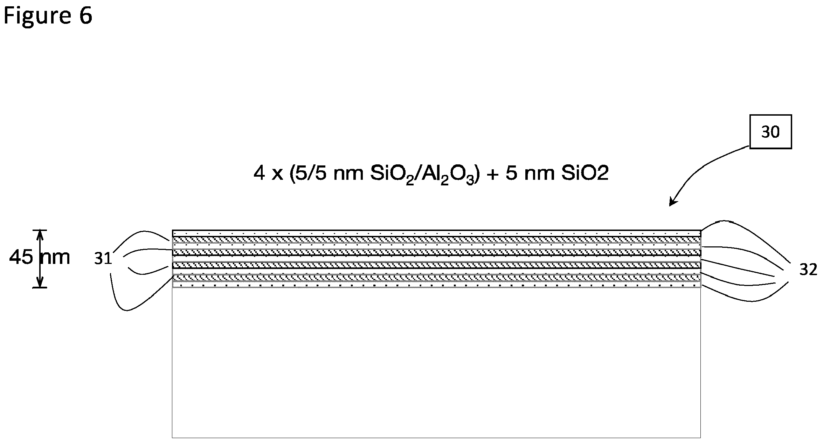

Figures 5 and 6 illustrate example ALD recipes for the moisture barrier layers 31 and the dielectric layers 32. The first example of the thin-film stack 30, illustrated in Figure 5, is about 100 nm thick total and is comprised of 10 alternating layers of, e.g., metallic oxide layers 31 (Al₂O₃) and dielectric layers 32 (SiO₂) each approximately 10 nm thick. The second example of the thin-film stack 30, illustrated in Figure 6, is thinner and more optically transparent, and has a total thickness of about 45 nm and is formed of 9 alternating moisture barrier layers 31 (Al₂O₃) and dielectric layers 32 (SiO₂), each layer being approximately 5 nm thick. One of the moisture barrier layers 31 may form the innermost layer proximate the optical edge coupler 5, and one of the dielectric layers 32 may form the outermost layer or vice versa. Alternatively, one of the moisture barrier layers 31 or one of the dielectric layers 32 may form both the innermost and outermost layers of the stack 30. In some embodiments, both the innermost and the outermost layers of the stack 30 may be layers of a same material as at least one of the lower cladding layer 12 and the upper cladding layer 13. In some embodiments, both the innermost and the outermost layers of the stack 30 may be silicon dioxide layers.

ALD is conformal and, in some embodiments, covers the entire photonic chip 1 with the multi-layer stack 30, even regions that could have cavities, such as the ones seen when doing a silicon isotropic etch. ALD produces high quality moisture barrier layers 31 and dielectric layers 32 that have good mechanical and optical properties. Multi-layer designs break moisture diffusion paths at every interface and helps seal the photonic chip 1. Thin layers (<50 nm and typically <25 nm) have low effective refractive indices compared to bulk thickness layers, and can be optically compatible with refractive index (RI) sensitive devices, such as optical grating couplers 4 and optical edge couplers 5, even if the bulk layer's RI wouldn't be compatible. ALD may deposit the multi-layer stack 30 at low temperatures (<400 °C), which are compatible with full flow photonic chips.

With reference to Figures 2 and 3, a method of manufacturing the PIC or photonic chip 1 with a moisture barrier includes: providing or forming the photonic chip 1 on the substrate 11. The photonic chip 1 includes the optical device layer 8 sandwiched between the lower cladding layer 12 and the upper cladding layer 13. The optical input/output (IO), e.g. in the form of an optical grating coupler 4 and/or an optical edge coupler 5, is provided or formed above the optical device layer 8 enabling light to be transmitted to and/or from the optical device layer from the near end of an external waveguide, e.g. the optical fiber 22. The electrical IO pads 2 are provided on the upper surface 3 with a plurality of superposed metallic contact structures 17 and vias 18 electrically connecting the pads 2 with components on the optical device layer 8.

Forming the electrical connector structure may comprise: a) depositing an etch stop layer 14; b) depositing a dielectric layer 15 over the etch stop layer 14; c) etching an opening in the dielectric layer 15 down to the etch stop layer 14; d) depositing metal in the opening to form one or more of the metallic contact structures 17; and repeating steps a) to d) to form the plurality of superposed metallic contact structures 17 stacked above the optical device layer 8.

Preferably but not exclusively, the optical edge coupler 5 and waveguide segments 7 and 21 optically coupling the optical IOs to the optical device layer 8 may be formed from etch stop layers 14 provided in the photonic chip 1 for defining the metallic contact structures 17.

The thin-film stack 30 may be applied over the entire photonic chip 1, e.g. with ALD encapsulation (Fig. 2). The thin-film stack 30 is conformal and may cover features on the top surface 3 of the photonic chip 1, e.g. the electrical IO pads 2, but also would cover etch facets (~10°) on the edge 6 of the photonic chip 1, and bottom-of-chip features, such as the interface for the substrate 11 and the PIC 1, e.g. lower cladding layer 12. Subsequent etching steps (Fig. 3) are performed to remove portions of the thin-film stack 30 from the electrical IO pads 2 to enable probing/wire-bonding/bumping thereto. The thin-film stack 30 may be thin enough such that it does not affect the optical IOs, e.g. optical grating coupler 4 or optical edge coupler 5; however, the thin-film stack should also be thick enough to shield the photonic chip 1 from moisture.

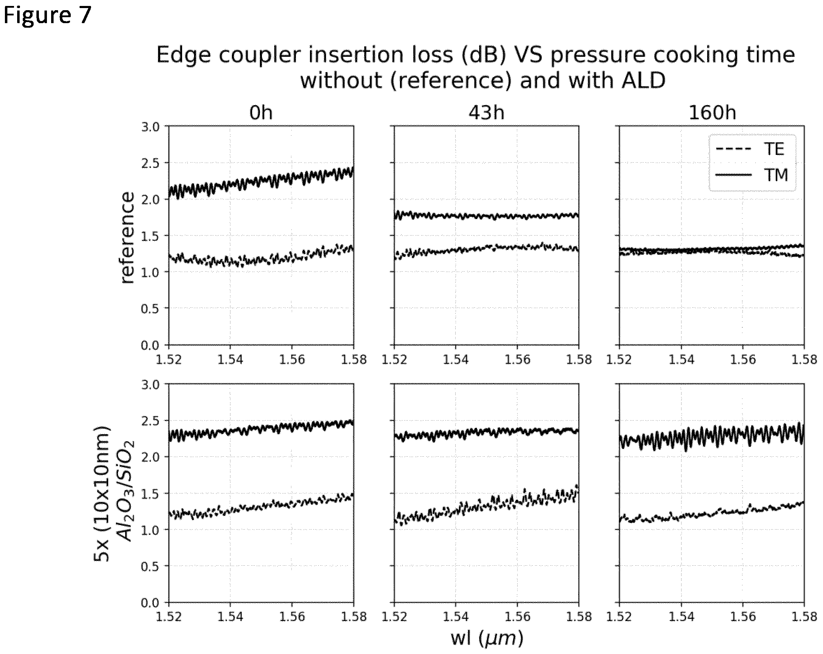

The top row of plots, provided in Fig. 7, illustrate the insertion loss of an optical edge coupler 5 in (dB) as a function of time in a pressure cooker, i.e. a high temperature & humidity environment without a moisture barrier. Both the wavelength dependency and the PDL changes over time, which is undesirable. The second row of plots shows a photonic chip 1 encapsulated with a moisture barrier formed by the thin-film stack 30, and illustrates a much more stable operation of the device over time.

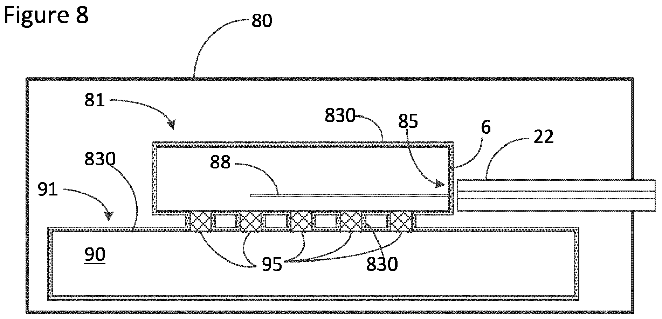

Fig. 8 illustrates a photonic chip 81 fixedly attached along a facing surface 91 of a carrier substrate 90. The photonic chip 81 may be an embodiment of the photonic chip 1 or the photonic chip 41 described above. The photonic chip 81 includes at least an optical waveguide 88 terminating at an edge 6 of the chip to form an optical edge coupler 85. The optical edge coupler 85 may be an embodiment of the optical edge coupler 5 or the optical edge coupler 45 described above, and is configured for optically coupling to a near end of an optical fiber 22. An ALD-applied coating stack 830 ("coating 830") covers at least the edge 6 of the chip and at least a portion of the facing surface 91 to form a moisture-protective barrier. The coating 830 may be e.g. as described above with reference to the moisture barrier multi-layer stack 30. The coating 830 may include a stack of interleaving first and second dielectric layers of different material composition, e.g. layers 31 and 32 as described above, the stack including at least 2 pairs of the layers, with at least three 3 interfaces between adjacent ones of the first and second layers therein. In the illustrated embodiment, the photonic chip 81 is attached to the surface 91 of the carrier 90 with one or more metal, e.g. copper, pillars 95, e.g., via solder. Furthermore, in the illustrated embodiment, the coating 30 is applied to the chip-carrier assembly 81/90 using the ALD at a low enough temperature to preserve any previous soldering. The ALD-applied coating 830 conforms to all exposed surfaces of the assembly, as shown in the illustrated example, desirably provided an effective barrier to external moisture. The chip-carrier assembly 81/90 may therefore be disposed within a non-hermetic housing 80.

The foregoing description of one or more embodiments of the invention has been presented for the purposes of illustration and description. It is not intended to be exhaustive or to limit the invention to the precise form disclosed. Many modifications and variations are possible in light of the above teaching. For example, various features described above with reference to the photonic chip 1, e.g. the optical grating coupler(s) 4, the electrical IO pads 2, the device layer 8, may be absent in other embodiments. Furthermore, in some embodiments the optical edge coupler 5 may be formed without the segments 21, e.g. by an end of the optical waveguide 7 or of the device layer 8 that is proximate to the chip edge 6, e.g. terminating at the edge 6. In some embodiments the optical edge coupler 5 may be configured for coupling to a waveguide of another optical device, e.g. to an end of an optical waveguide of another optical chip, with or without one or more coupling optical elements therebetween. In some embodiments, the coating 30 may cover only a portion, e.g. half or more, of the surface of the photonic chip. In some embodiments, the coating 30 may be up to 150 nm thick.

Furthermore, although the first layers 31 are referred to herein as moisture barrier layers, the underlying physical mechanism preventing moisture to penetrate the coating 30 may be related mostly, or to at least in part, to the interfaces 31/32 between the first (32) and second (31) layers of different material composition, rather than to the layers 31 themselves and thicknesses thereof. Accordingly, relatively thin layers 31, e.g. 4-10 nanometers thick layers of, e.g, SiN, may provide an effective moisture barrier in embodiments with a suitable number of the layer interfaces 31/32, e.g. at least 3, or preferably 4-10 or more such interfaces 31/32 The first layers 32, typically having a smaller refractive index, e.g. SiO2 layers, may be thicker than the second layers 31, e.g. 10-20 nm.

According to example embodiments disclosed above, e.g., in the summary section and/or in reference to any one or any combination of some or all of FIGs. 1-7, provided is an apparatus comprising a photonic chip (e.g. 1, Figs. 1-3, 41, Figs. 4A, 4B, 81, Fig. 8), the photonic chip comprising an edge optical coupler (e.g. 5, Figs. 1-3, 45, Figs. 4A, 4B, 85 Fig. 8) for end-coupling an external optical waveguide to the photonic chip, the optical coupler having one end at an edge (e.g. 6, Figs. 1-3, 8), of the chip; and a coating (e.g. 30, Figs. 1-6, 830 Fig. 8) on, at least, a part of the edge of the chip over the one end of the optical edge coupler, the coating being a stack alternating first and second dielectric layers (e.g. 31 and 32, Figs. 5, 6) of different material composition, the stack including at least 2 interfaces between adjacent ones of the first and second layers.

The external optical waveguide may be an optical fiber or an optical waveguide of an external optical device, e.g. another photonic chip. Herein, the optical edge coupler(s) can optically couple to the external optical waveguide via an end thereof located near to an outside edge of the photonic chip and/or located near to an internal edge of the photonic chip. In some implementations, the edge of the photonic chip may be an edge of a recess in the photonic chip in which an external device, such as a laser, is inserted, so that an end of an optical waveguide of the external device is nearby, and optically coupled to, an optical edge coupler at the edge of the recess.

In some embodiments of the above apparatus, the coating (e.g. 30, Figs. 1-6) has a thickness of 10 to 150 nanometers. In some embodiments of the above apparatus, the coating covers at least half of a surface of the photonic chip. In some embodiments of the above apparatus, each second layer (e.g. 31, Figs. 5, 6) of the coating is thinner than each first layer (e.g. 32, Figs. 5, 6). In some embodiments of the above apparatus, each second layer is one of a silicon nitride layer, a hafnium oxide layer, and an aluminum oxide layer. In some embodiments of the above apparatus, each first layer is a silicon-oxide layer. In some embodiments, the stack starts and ends with a silicon dioxide layer.

Some embodiments of the above apparatus comprise a carrier, and the photonic chip is attached along a facing major planar surface of the carrier, with the coating being disposed over at least a part of the surface. In some embodiments of the above apparatus, the stack has at least four of the layers. In some embodiments of the above apparatus, each second layer is thinner than each first layer of the stack. In some embodiments of the above apparatus, the coating has a thickness of less than 100 nanometers.

Some embodiments of the above apparatus may further comprise a non-hermetic package including the substrate, the photonic chip being mounted on a surface the substrate and being located in the package, the coating substantial protecting the optical edge coupler from ambient moisture.

According to another example embodiment disclosed above, e.g., in the summary section and/or in reference to any one or any combination of some or all of FIGs. 1-7, provided is a method comprising performing atomic layer deposition (ALD) to coat at least part of an edge of a photonic chip with a stack of at least three dielectric layers, adjacent ones of the dielectric layers of the stack having different material compositions. In some embodiments of the above method, the part is adjacent one end of an optical fiber coupler located in the photonic chip. In some embodiments of the above method, the performing produces the stack such that thicknesses of the layers of the stack alternate thereacross. In some embodiments of the above method, the atomic layer deposition is performed after soldering the photonic chip to a carrier.

Unless explicitly stated otherwise, each numerical value and range in the above description should be interpreted as being approximate as if the word "about" or "approximately" preceded the value or range.

Various modifications of the described embodiments, as well as other embodiments within the scope of the disclosure, which are apparent to persons skilled in the art to which the disclosure pertains are deemed to lie within the principle and scope of the disclosure, e.g., as expressed in the following claims. It is thus intended that the scope of the invention be limited not by this detailed description, but rather by the claims appended hereto.

## Claims

1. An apparatus comprising:
a photonic chip comprising an optical edge coupler for end-coupling an external optical waveguide to the photonic chip, the optical coupler having one end at an edge of the chip; and
a coating on, at least, a part of the edge of the chip over the one end of the optical edge coupler, the coating being a stack interleaving first and second dielectric layers of different material composition, the stack including at least 2 interfaces between adjacent ones of the first and second layers.

2. The apparatus of claim 1, wherein the coating covers at least half of a surface of the photonic chip.

3. The apparatus of claim 1, wherein the external optical waveguide is an optical fiber.

4. The apparatus of claim 1, wherein each second layer is one of a silicon nitride layer, aluminum oxide layer, and a hafnium oxide layer.

5. The apparatus of claim 4, wherein each first layer is a silicon-oxide layer.

6. The apparatus of claim 5, wherein each second layer is thinner than each first layer.

7. The apparatus of claim 1, wherein the stack starts and ends with a silicon-dioxide layer.

8. The apparatus of claim 1 comprising a carrier, wherein the photonic chip is attached along a facing surface of the carrier; and wherein the coating is disposed over at least a part of the surface.

9. The apparatus of clam 1, wherein the stack has at least four of the layers.

10. The apparatus of claim 1, wherein each of the layers is less than 25 nm thick.

11. The apparatus of claim 1, wherein the coating has a thickness of less than 100 nanometers.

12. The apparatus of claim 1, further comprising a non-hermetic package including a substrate, the photonic chip being mounted on a surface of the substrate and being located in the package, the coating substantially protecting the optical edge coupler from ambient moisture.

13. A method comprising:
performing atomic layer deposition to coat at least a part of an edge of a photonic chip with a stack of at least three dielectric layers, adjacent ones of the dielectric layers having different material compositions.

14. The method of claim 13, wherein the part is adjacent one end of an optical fiber coupler located in the photonic chip.

15. The method of claim 13, wherein the performing produces the stack such that thicknesses of the layers of the stack alternate thereacross.

16. The method of claim 13, wherein the atomic layer deposition is performed after soldering the photonic chip to a carrier.
